# EUROPÄISCHE PATENTANMELDUNG

(11) **EP 1 174 906 A1**
(43) Veröffentlichungstag der Anmeldung: **23.01.2002**
(21) Anmeldenummer: 00810654.4
(22) Anmeldetag: 21.07.2000
(51) Int. Cl.: H01L 21/00

(54) **Vorrichtung zur Herstellung von Drahtverbindungen**

(71) Anmelder: Esec Trading S.A., 6330 Cham (CH)
(72) Erfinder: Hess, Peter, 6300 Zug (CH); Durrer, Carlo, 6374 Buochs (CH); Ottiger, Elmar, 6010 Kriens (CH)
(74) Vertreter: Falk, Urs, Dr.

(57) **Zusammenfassung**

Eine Vorrichtung zur Herstellung von Drahtverbindungen zwischen einer ersten Anschlussfläche (2) und einer zweiten Anschlussfläche (3) mittels einer Kapillare (10) enthält ein Bilderkennungssystem, das so ausgebildet ist, dass die Spitze (27) der Kapillare (10) unmittelbar vor dem Auftreffen auf der jeweiligen Anschlussfläche (2) in den Bildbereich des Bilderkennungssystems gelangt. Somit können sowohl die Lage des Soll-Auftreffpunktes der Kapillare (10) auf der Anschlussfläche (2) als auch die Lage der Spitze (27) der Kapillare (10) mit dem gleichen Messsystem erfasst, ausgewertet und zur präzisen Steuerung der Bewegung der Kapillare (10) verwendet werden.

## Beschreibung

Die Erfindung betrifft eine Vorrichtung zur Herstellung von Drahtverbindungen der im Oberbegriff des Anspruchs 1 genannten Art.

Solche Vorrichtungen sind in der Halbleiterindustrie allgemein unter dem Namen Wire Bonder bekannt. Der Wire Bonder weist einen in der horizontalen Ebene beweglich geführten Bondkopf auf. Der Bondkopf umfasst eine um eine horizontale Drehachse drehbare Wippe mit einem Horn, an dessen Spitze eine den Bonddraht führende Kapillare eingespannt ist. Der Bondkopf umfasst weiter ein Bilderkennungssystem zur Erfassung der Lage der Pads auf den Halbleiterchips. Das Bilderkennungssystem ist so konstruiert und angeordnet, dass sich sein Blickfeld seitlich neben der Kapillare befindet, wobei die optische Achse des Bilderkennungssystems senkrecht auf den Halbleiterchip bzw. das Substrat auftrifft. D.h. die Strahlen des Bilderkennungssystems verlaufen im wesentlichen parallel zur Längsachse der Kapillare.

Temperaturschwankungen führen dazu, dass sich die optische Achse und die Spitze der Kapillare relativ zueinander verschieben können. Diese Temperaturdrift bewirkt, dass die Kapillare den Bonddraht nicht mehr am vorgesehenen Sollpunkt auf dem Pad absetzt. Um solche Fehlplatzierungen zu vermeiden, muss bei den sogenannten Fine Pitch und Ultra Fine Pitch Applikationen, bei denen der Abstand von Padmittelpunkt zu Padmittelpunkt nur 50µm oder sogar nur 35µm beträgt, die Lage der Kapillare zur optischen Achse des Bilderkennungssystems in kurzen zeitlichen Abständen neu bestimmt werden.

Der Erfindung liegt die Aufgabe zugrunde, ein Messsystem zu entwickeln, mit dem sich die Lage der Kapillare zu dem zu bondenden Pad selbst bei sehr kleinem Abstand von Padmittelpunkt zu Padmittelpunkt von nur 35µm oder sogar nur noch 20µm auch bei Temperaturschwankungen zuverlässig bestimmen lässt.

Die Erfindung besteht in den im Anspruch 1 angegebenen Merkmalen. Vorteilhafte Ausgestaltungen ergeben sich aus den abhängigen Ansprüchen.

Eine erfindungsgemässe Vorrichtung zur Herstellung von Drahtverbindungen zwischen einer ersten Anschlussfläche und einer zweiten Anschlussfläche mittels einer Kapillare enthält ein Bilderkennungssystem, das so ausgebildet ist, dass die Spitze der Kapillare unmittelbar vor dem Auftreffen auf der jeweiligen Anschlussfläche in den Bildbereich des Bilderkennungssystems gelangt. Somit können sowohl die Lage des Soll-Auftreffpunktes der Kapillare auf der Anschlussfläche als auch die Lage der Spitze der Kapillare mit dem gleichen Messsystem erfasst, ausgewertet und zur präzisen Steuerung der Bewegung der Kapillare verwendet werden.

Das Bilderkennungssystem umfasst eine Optik und eine Kamera, wobei die Optik die in einer horizontalen Ebene liegende Anschlussfläche mit vorbestimmter Vergrösserung auf die Kamera abbildet und so konstruiert ist, dass die Kamera die jeweilige Anschlussfläche nicht senkrecht von oben, sondern schräg unter einem vorbestimmten Winkel zur Vertikalen sieht und zwar dann, wenn sich die Anschlussfläche unterhalb der Spitze der Kapillare befindet.

Solange die Höhe der Kapillarenspitze über der jeweiligen Anschlussfläche nicht bekannt ist, kann die Lage der Kapillarenspitze bezüglich der Anschlussfläche nur bezüglich der quer zur Blickrichtung verlaufenden Koordinatenrichtung bestimmt werden. Um die Lage der Kapillarenspitze auch bezüglich einer zweiten Koordinatenrichtung bestimmen zu können, wird erfindungsgemäss vorgeschlagen, das Bilderkennungssystem um eine zweite Optik und eine zweite Kamera zu erweitern, wobei die zweite Kamera die Anschlussfläche aus einer zweiten Blickrichtung sieht. Eine weitere Möglichkeit besteht darin, die Kapillare unter definierten Bedingungen zu beleuchten und die Lage der Kapillarenspitze bezüglich der zweiten Koordinatenrichtung unter Berücksichtigung auch des Schattens der Kapillare zu bestimmen.

Nachfolgend werden diese beiden Beispiele der Erfindung als bevorzugte Ausführungsbeispiele anhand der Zeichnung näher erläutert.

Es zeigen:
- Fig. 1: Teile einer Vorrichtung zur Herstellung von Drahtverbindungen in schematischer Darstellung,
- Fig. 2: Teile der Vorrichtung in Aufsicht,
- Fig. 3: ein von einer Kamera aufgenommenes Bild,
- Fig. 4: ein weiteres von der Kamera aufgenommenes Bild.
- Fig. 5: Teile einer weiteren Vorrichtung zur Herstellung von Drahtverbindungen,
- Fig. 6: geometrische Verhältnisse zwischen der Beleuchtung der Kapillare und der Aufnahmerichtung der Kamera. und
- Fig. 7, 8: von der Kamera aufgenommene Bilder.

### Ausführungsbeispiel 1

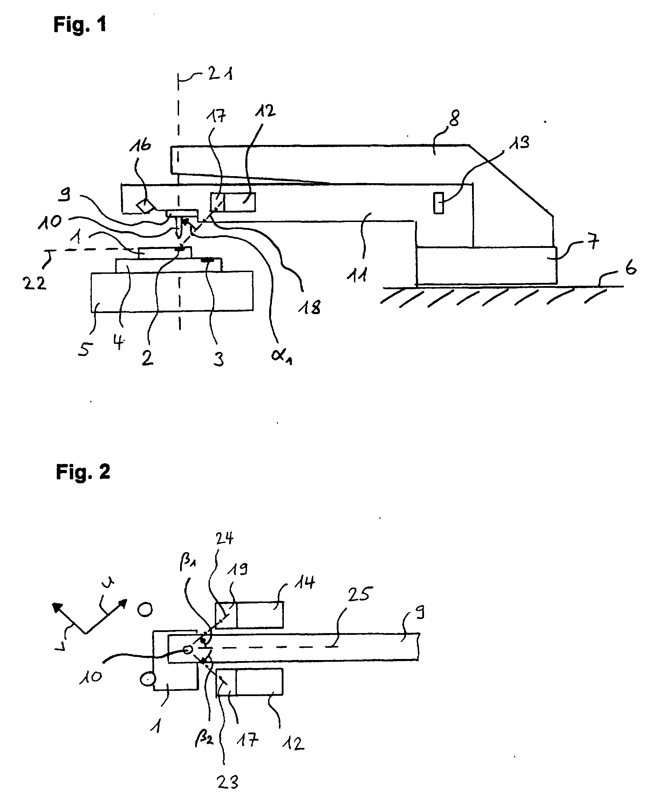

Die Fig. 1 zeigt in schematischer, nicht massstabsgetreuer Darstellung die für das Verständnis der Erfindung notwendigen Teile einer Vorrichtung zur Herstellung von Drahtverbindungen zwischen einer ersten, auf einem Halbleiterchip 1 befindlichen Anschlussfläche 2, einem sogenannten Pad, und einer zweiten Anschlussfläche 3. Der Halbleiterchip 1 befindet sich auf einem Substrat 4, das auf einem Auflagetisch 5 für die Herstellung der Drahtverbindungen bereitgestellt wird. Die zweite Anschlussfläche 3 befindet sich z.B. auf dem Substrat 4. Die Vorrichtung weist einen in einer horizontalen Ebene 6 beweglichen Bondkopf 7 auf. Der Bondkopf 7 umfasst eine um eine horizontale Achse drehbare Wippe 8, an der ein mit Ultraschall beaufschlagbares Horn 9 befestigt ist. An der Spitze des Horns 9 ist eine Kapillare 10 eingespannt. Die Kapillare 10 dient sowohl zum Befestigen eines Drahtes an den beiden Anschlussflächen 2, 3 als auch zur Drahtführung zwischen diesen. Am Bondkopf 7 ist ein Optikträger 11 mit optischen Elementen zum Vermessen der Lage der Anschlussflächen 2 bzw. 3 und der Lage der Spitze der Kapillare 10 befestigt. Die optischen Elemente gehören zu einem Bilderkennungssystem. Der Optikträger 11 befindet sich seitlich neben dem Horn 9.

Beim ersten Ausführungsbeispiel besteht das Bilderkennungssystem aus zwei Teilsystemen, nämlich einer ersten Optik 12 und einer ersten Kamera 13 und aus einer zweiten Optik 14 und einer zweiten Kamera 15, Beleuchtungsmitteln 16, sowie elektronischen Bildverarbeitungsmodulen zur Verarbeitung und Auswertung der von den beiden Kameras 13 und 15 gelieferten Bilder. In der Seitenansicht der Fig. 1 sind die zweite Optik 14 und die zweite Kamera 15 nicht sichtbar. Die erste Optik 12 ist im Strahlengang zwischen dem Halbleiterchip 1 und der ersten Kamera 13 angeordnet, Sie besteht aus optischen Elementen, die das auf die Kamera 13 projizierte Bild des Halbleiterchips 1 vergrössern, beispielsweise um den Faktor 8, und aus einem ersten Spiegel 17, der so angeordnet ist, dass die erste Kamera 13 den Halbleiterchip 1 bzw. das Substrat 4 aus einer ersten vorbestimmten Richtung 18 sieht. Die zweite Optik 14 ist im Strahlengang zwischen dem Halbleiterchip 1 und der zweiten Kamera 15 angeordnet. Sie ist analog zur ersten Optik 14 aufgebaut und weist einen zweiten Spiegel 19 (Fig. 2) auf, der so angeordnet ist, dass die zweite Kamera 15 den Halbleiterchip 1 bzw. das Substrat 4 aus einer zweiten vorbestimmten Richtung 20 (nicht sichtbar) sieht. Die Richtungen 18 und 20 entsprechen den optischen Achsen der beiden Optiken 12 bzw. 14 auf ihrer der Kapillare 10 zugewandten Seite.

Die Fig. 2 zeigt in Aufsicht den Halbleiterchip 1 das Horn 9, die Kapillare 10, die beiden Optiken 12, 14 mit den Spiegeln 17, 19 und die Beleuchtungsmittel 16. Der Optikträger 11 (Fig. 1) ist aus Gründen der zeichnerischen Klarheit nicht gezeichnet. Mit gestrichelten Linien sind die Richtungen 18 und 20 in ihrer Projektion 23 bzw. 24 auf die Ebene 22 (Fig. 1) des Halbleiterchips 1 dargestellt. Die Richtungen 18 (Fig. 1) und 20 können je durch Polarkoordinaten (α₁, β₁) bzw. (α₂, β₂) charakterisiert werden, wobei der Winkel α den Winkel zur Vertikalen 21 (Fig. 1) und der Winkel β den Winkel bezüglich einer vorbestimmten horizontalen Richtung 25 bezeichnet.

Der in der Ebene 22 senkrecht zur Projektion 23 der Richtung 18 verlaufenden Achse ist die Koordinatenachse u zugeordnet. Der in der Ebene 22 senkrecht zur Projektion 24 der Richtung 20 verlaufenden Achse ist die Koordinatenachse v zugeordnet. Die Koordinatenachsen u und v schliessen den Winkel ϕ = β₂ + β₁ ein. Die Richtungen 18 und 20 sind vorzugsweise so gewählt. dass der Winkel ϕ etwa 90° beträgt. Die beiden Winkel α₁ und α₂ sind verschieden von Null, bevorzugt gleich gross und liegen bevorzugt im Bereich zwischen 10° und 30°. Das durch die Koordinatenachsen u, v aufgespannte Koordinatensystem ist der Klarheit wegen parallel verschoben zu den Projektionen 23, 24 der Richtungen 18 und 20 dargestellt.

Die Kameras 13,15 liefern je ein zweidimensionales Bild, das z.B. aus 640 * 480 Pixeln besteht. Jedem Bild ist ein rechtwinkliges Koordinatensystem mit den Bildachsen x und y zugeordnet. Die horizontale x-Achse des Bildes der ersten Kamera 13 entspricht der Koordinatenachse u, während die vertikale y-Achse des Bildes der ersten Kamera 13 der Koordinatenachse v entspricht (aber nur dann, wenn der Winkel ϕ = 90° beträgt). Die Koordinatenachse u wird unverzerrt und massstabsgetreu auf die x-Achse der ersten Kamera 13 abgebildet, während die Koordinatenachse v verzerrt und nicht massstabsgetreu auf die y-Achse der ersten Kamera 13 abgebildet wird. Bei der zweiten Kamera 15 ist es umgekehrt: Dort wird die Koordinatenachse v unverzerrt und massstabsgetreu auf die x-Achse der zweiten Kamera 15 abgebildet, während die Koordinatenachse u verzerrt und nicht massstabsgetreu auf die y-Achse der Kamera 15 abgebildet wird.

Mittels einer Eichmessung wird die Beziehung zwischen der x-Achse des Bildes der ersten Kamera 13 und der Koordinatenachse u als auch die Beziehung zwischen der x-Achse des Bildes der zweiten Kamera 15 und der Koordinatenachse v bestimmt, damit sie für die Korrektur der Bahnbewegung der Kapillare 10 zur Verfügung stehen. D.h. nach der Eichung kann jedem Pixel der ersten Kamera 13 ein Wert der Koordinatenachse u zugeordnet werden und jedem Pixel der zweiten Kamera 15 kann ein Wert der Koordinatenachse v zugeordnet werden.

Das Bilderkennungssystem dient dazu, den voraussichtlichen Auftreffpunkt der Kapillare 10 auf der Anschlussfläche 2 des Halbleiterchips 1 unmittelbar vor dem Auftreffen zu bestimmen, damit bei zu grosser Abweichung des voraussichtlichen Auftreffpunktes vom gewünschten Auftreffpunkt die Bewegung der Kapillare 10 korrigiert werden kann. Zu diesem Zweck werden zwei aufeinanderfolgende Messungen durchgeführt. Die erste Messung dient dazu, die Lage des vorprogrammierten Auftreffpunktes der Kapillare 10 auf der Anschlussfläche 2 zu bestimmen. Die erste Messung erfolgt vorzugsweise, während sich die Kapillare 10 ausserhalb des Blickfeldes der Kameras 13, 15 befindet und die Sicht auf die Anschlussfläche 2 nicht verdeckt.

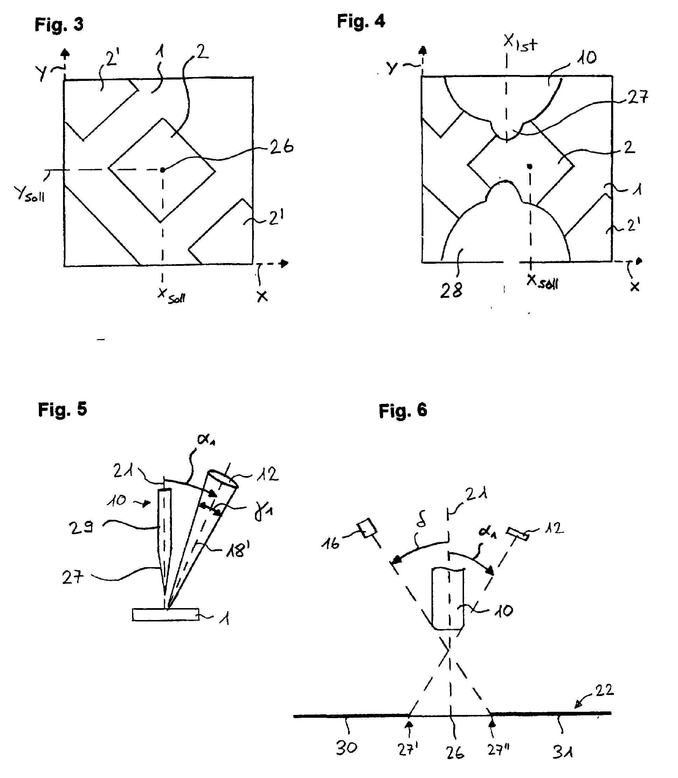

Die Fig. 3 zeigt das bei der ersten Messung von der Kamera 13 aufgenommene Bild des Halbleiterchips 1, der nur ausschnittsweise im Bild ist. Die Anschlussfläche 2 erscheint als helle Fläche auf dunklem Hintergrund. Im Bild sind zudem Teile benachbarter Anschlussflächen 2' sichtbar. Mittels eines an sich bekannten Algorhythmus wird nun die Pixelkoordinate xₛₒₗₜ des Soll-Auftreffpunktes 26 der Kapillare 10 ermittelt. Die Pixelkoordinate yₛₒₗₗ muss hier nicht bestimmt werden. Auch wenn jeder Pixel der Kamera 13 durch ein Paar von ganzen Zahlen charakterisiert ist, muss die durch die Auswertung des Bildes der ersten Kamera 13 bestimmte Pixelkoordinate x_{Soll} des Soll-Auftreffpunktes 26 nicht ganzzahlig sein.

Die zweite Messung dient zur Bestimmung der Lage der Spitze der Kapillare 10. Die zweite Messung erfolgt, wenn die Kapillare 10 ihre sogenannte Suchhöhe H über der Anschlussfläche 2 erreicht hat und kurzzeitig stillsteht oder während die Kapillare 10 die Suchhöhe H durchläuft. Die Suchhöhe H ist ein vorbestimmter Punkt auf dem Bahnabschnitt, den die Kapillare 10 unmittelbar vor dem Auftreffen (Touchdown) auf dem Halbleiterchip 1 durchläuft. Die Suchhöhe H befindet sich typischerweise 100µm bis 150µm oberhalb der Oberfläche des Halbleiterchips 1. Auf ihrer stark beschleunigten Bewegung schwingt die Kapillare 10 in der Regel. Sobald die Kapillare 10 die Suchhöhe H erreicht hat oder mit relativ geringer Geschwindigkeit durchläuft, sind diese Schwingungen soweit abgeklungen, dass die zweite Messung erfolgen kann.

Die Fig. 4 zeigt das bei der zweiten Messung von der Kamera 13 aufgenommene Bild. Teile der Anschlussfläche 2 sind nun durch die Kapillare 10 verdeckt. Als dunkle Fläche ist zudem der Schatten 28 der Kapillare 10 sichtbar. Der Schatten 28 der Kapillare 10 wirkt so, als ob Teile der Anschlussfläche 2 verdeckt wären. Die Spitze 27 der Kapillare 10 erscheint als halbkreisförmige Fläche, und mittels bekannten Bildanalyseverfahren ist es möglich, die Pixelkoordinate xᵢₛₜ des voraussichtlichen Auftreffpunkts der Spitze 27 der Kapillare 10 zu bestimmen. Im dargestellten Beispiel weicht die Spitze 27 der Kapillare 10 um die Pixeldistanz Δx1 = x_{Ist} - xₛₒₗₗ von ihrer Solllage in x-Richtung ab. Diese Abweichung kann nun in eine physikalische Distanz Δu auf der Koordinatenachse u umgerechnet und eine entsprechende Korrekturbewegung der Kapillare 10 in Bezug auf die Koordinatenachse u veranlasst werden.

Die Pixelkoordinate y_{Ist} des voraussichtlichen Auftreffpunktes der Kapillare 10 auf der Anschlussfläche 2 in y-Richtung hingegen kann aus dem Abbild der Kapillare 10 im Bild der Kamera 13 nicht bestimmt werden, weil die genaue Höhe der Kapillare 10 über der Anschlussfläche 2 nicht bekannt ist. Mittels der beiden von der zweiten Kamera 15 aufgenommenen Bilder können jedoch in gleicher Weise die Pixelkoordinaten xₛₒₗₗ und x_{Ist} ermittelt werden, wobei die Koordinate \ wiederum die horizontale x-Achse der Kamera 15 bezeichnet. Die Pixeldistanz Δx2 = x_{Ist} - xₛₒₗₗ entspricht bei der zweiten Kamera 15 aber einer physikalischen Distanz Δv auf der Koordinatenachse v. Aufgrund der ermittelten Pixeldistanz Δx2 kann somit eine Korrekturbewegung der Kapillare 10 in Bezug auf die Koordinatenachse v eingeleitet werden.

Es ist unter Umständen möglich, die erste Messung wegzulassen und die Information über die Lage des Soll-Auftreffpunktes der Kapillare 10 und die voraussichtliche Lage des Auftreffpunktes der Kapillare 10 aus den beiden bei der zweiten Messung aufgenommenen Bildern zu bestimmen.

Die beiden Strahlengänge zwischen dem Halbleiterchip 1 und den beiden Kameras 13 und 15 sind bezüglich der Längsachse des Horns 9 (Fig. 1) symmetrisch ausgebildet und unterscheiden sich nur im Winkel β. unter dem der Halbleiterchip 1 und die Kapillare 10 von der zugeordneten Kamera 13 bzw. 15 gesehen werden. Im folgenden wird daher anhand der Fig. 5 nur der zwischen dem Halbleiterchip 1 und der ersten Kamera 13 gebildete Strahlengang beschrieben. dessen Eigenschaften durch den Winkel α₁ und die erste Optik 12 bestimmt sind.

Damit die zweite Messung überhaupt möglich ist, muss sich die Spitze 27 der Kapillare 10 im Blickfeld der Kamera 13 und damit innerhalb des Öffnungswinkels γ₁ der Optik 12 befinden. Daraus folgt, dass der Winkel α₁ der optischen Achse 18' zur Vertikalen 21 und der Öffnungswinkel γ₁ der Optik 12 entsprechend der Form der Kapillare 10 so zu wählen und gegenseitig abzustimmen sind, dass die Spitze 27 der Kapillare 10 nicht durch den Schaft 29 der Kapillare 10 verdeckt wird: Der Winkel α₁ sollte also möglichst gross sein. Andererseits darf die Sicht auf die zu bondende Anschlussfläche 2 des Halbleiterchips 1 nicht durch bereits gebondete Drähte verdeckt werden: Der Winkel α₁ sollte also möglichst klein sein.

Der Öffnungswinkel γ₁ der Optik 12 soll möglichst klein sein, damit die Sicht weder durch den Schaft 29 der Kapillare 10 noch durch bereits gebondete Drähte verdeckt wird. Andererseits bestimmt der Öffnungswinkel γ₁ das optische Auflösungsvermögen der Optik 12 und damit die erzielbare optische Auflösung: Je grösser der Öffnungswinkel γ₁ ist, desto grösser ist das optische Auflösungsvermögen, desto kleiner ist aber die Tiefenschärfe, Der Öffnungswinkel γ₁ und der Vergrösserungsfaktor der Optik 12 sind so festzulegen, dass sowohl die Anschlussfläche 2 als auch die Spitze 27 der Kapillare 10, wenn sie sich auf der Suchhöhe H befindet, ausreichend scharf auf die Kamera 13 abgebildet werden. Der Vergrösserungsfaktor ist zudem so zu wählen, dass die optische Auflösung und das durch den Pixelabstand gegebene Auflösungsvermögen der Kamera 13 einander entsprechen.

Das optische Auflösungsvermögen hängt aber nicht nur vom Öffnungswinkel γ₁ der Optik 12, sondern auch von der Wellenlänge λ des von den Beleuchtungsmitteln abgestrahlten Lichtes ab. Je kleiner die Wellenlänge λ ist, desto grösser ist bei vorgegebenem Öffnungswinkel γ₁ das Auflösungsvermögen. Bevorzugt wird daher für die Beleuchtung blaues Licht verwendet. Beim versuchsweisen Einsatz auf einem bestehenden Wire Bonder des Modells 3088 der Anmelderin hat sich eine Optik 12 mit einem Öffnungswinkel γ₁ von etwa 15° und einem Vergrösserungsfaktor von 8 bewährt.

Die Beleuchtungsmittel 16 sind vorzugsweise so angeordnet, dass das an der Anschlussfläche 2 gespiegelte Licht auf die optische Achse 18' fällt. Dies ergibt einen hohen Kontrast zwischen der Anschlussfläche 2 und ihrer Umgebung, so dass eine einwandfreie Bildauswertung bei vergleichsweise geringer Lichtleistung möglich ist. Möglich ist aber auch eine diffuse Beleuchtung, die zwar zu einem geringeren Kontrast, aber besserer Detailwiedergabe führt.

Die beiden Kameras 13 und 15 können als CCD Kameras auf einem einzigen Chip realisert sein, wobei die beiden Optiken 12 und 14 ihre Bilder auf benachbarte Bereiche des CCD Chips projizieren.

### Ausführungsbeispiel 2

Beim zweiten Ausführungsbeispiel sind im Gegensatz zum ersten Ausführungsbeispiel nur die erste Optik 12 und die erste Kamera 13 vorhanden, während die zweite Optik 14 und die zweite Kamera 15 entfallen. Die Bestimmung einer allfälligen Abweichung des zu erwartenden Auftreffpunktes der Spitze der Kapillare 10 vom Soll-Auftreffpunkt in Bezug auf die Richtung der Koordinatenachse u erfolgt wie beim ersten Ausführungsbeispiel. Für die Bestimmung einer allfälligen Abweichung des zu erwartenden Auftreffpunktes der Spitze der Kapillare 10 vom Soll-Auftreffpunkt in Bezug auf die Richtung der 5 Koordinatenachse v hingegen wird nun auch der Schatten der Kapillare 10 herangezogen. Bei diesem Ausführungsbeispiel entspricht die Koordinatenachse v der Richtung der Projektion 23 der Richtung 18. Damit dies möglich ist, sind die Beleuchtungsmittel 16 so angeordnet, dass das ausgesandte Licht unter dem Winkel δ = α₁ auf die Anschlussfläche 2 auftrifft, wobei ja der Winkel α₁ den Winkel bezüglich der Vertikalen 21 darstellt, unter dem die Kamera 13 die Anschlussfläche 2 sieht. In der Fig. 6 sind die sich ergebenden geometrischen Verhältnisse dargestellt, wobei die Fig. 6 einen Schnitt durch die durch die Vertikale 21, welche längs durch die Kapillare 10 verläuft, und die Richtung 18 aufgespannte Ebene zeigt. Es bezeichnen das Bezugszeichen 30 das aufdie Ebene 22 projizierte Bild der Kapillare 10 und das Bezugszeichen 31 den auf die Ebene 22 fallenden Schatten der Kapillare 10. Das Bild der Kamera 13 entspricht einem Abbild der Ebene 22. Da die Winkel δ und α₁ gleich gross sind, sind im Bild der 5 Kamera 13 die Spitze 27' des Bildes 30 der Kapillare 10 und die Spitze 27" des Schattens 31 der Kapillare 10 gleich weit vom erwarteten Auftreffpunkt 26 der Kapillare 10 entfernt.

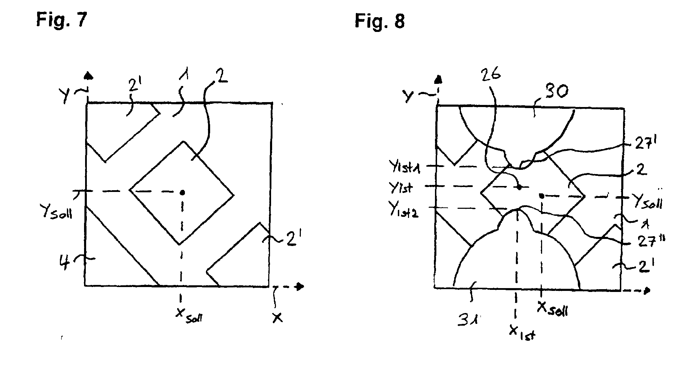

Bei der Auswertung des zuerst aufgenommenen Bildes wird nun. wie in der Fig. 7 gezeigt ist, aus dem Abbild der Anschlussfläche 2 nicht nur die Pixelkoordinate x_{Soll}, sondern auch die Pixelkoordinate y_{Soll} ermittelt. Aus dem zweiten aufgenommenen Bild, das in der Fig. 8 dargestellt ist, wird anschliessend wie beim ersten Ausführungsbeispiel die Pixelkoordinate x_{Ist} bestimmt. Zudem werden durch Auswertung des Abbildes 30 der Kapillare 10 die Pixelkoordinate y_{ISt1} der Kapillarenspitze 27' und durch Auswertung des Bildes des Schattens 31 die Pixelkoordinate y_{Ist2} der Spitze 27" des Kapillarenschattens 31 bestimmt. Die Pixelkoordinate y_{Ist} des voraussichtlichen Auftreffpunktes lässt sich dann berechnen zu yᵢₛₜ=½ (y_{Ist1} + y_{Ist2}). Der Korrekturvektor ergibt sich dann zu (Δx = x_{Ist} - xₛₒₗₗ, △y = yᵢₛₜ - yₛₒₗₗ). Dieser Korrekturvektor muss nun noch in einen dem Koordinatensystem u, v entsprechenden Korrekturvektor transformiert werden, damit die im Pixelsystem der Kamera 13 festgestellte Offsetlage der Kapillare 10 mittels einer Bewegungskorrektur zum Verschwinden gebracht werden kann, so dass die Kapillare 10 am richtigen Ort auf der Anschlussfläche 2 auftrifft. Damit dies möglich ist, muss vorgängig ein Eichvorgang durchgeführt werden, damit die im x,y Koordinatensystem der Kamera 13 ermittelten Distanzen in Distanzen im Koordinatensystem u,v umgerechnet werden können. Die Eichung kann beispielsweise so erfolgen, dass ein Bild einer mit Referenzpunkten versehenen Eichplatte aufgenommen, die Pixelkoordinaten der Referenzpunkte bestimmt, der Bondkopf dann um eine bestimmte Strecke im u,v Koordinatensystem verschoben, ein zweites Bild der Eichplatte aufgenommen und die neuen Pixelkoordinaten der Referenzpunkte bestimmt werden.

Das zweite Ausführungsbeispiel ist billiger als das erste Ausführungsbeispiel, da nur eine Optik, eine Kamera und ein Bildverarbeitungsmodul nötig sind. Das erste Ausführungsbeispiel bietet aber den Vorteil, dass zwei verschiedene Varianten zur Verfügung stehen, um den Offset der Kapillare 10 zu bestimmen. Grundsätzlich kann immer dann, wenn ein bereits gebondeter Draht den Strahlengang zwischen der Anschlussfläche 2 und der ersten Kamera 13 versperrt oder zumindest erheblich versperrt, eine Messung mittels der zweiten Optik 14 und der zweiten Kamera 15 gemäss dem zweiten Ausführungsbeispiel unter Berücksichtigung der im Schatten der Kapillare enthaltenen Information durchgeführt werden. Umgekehrt kann eine Messung mittels der ersten Optik 12 und der ersten Kamera 13 gemäss dem zweiten Ausführungsbeispiel durchgeführt werden, wenn der Strahlengang zur zweiten Kamera 15 versperrt ist.

Die Auswertung der von den Kameras 13 und 15 gelieferten Bilder benötigt unter Umständen mehr Zeit als ohne Durchsatzverlust zur Verfügung steht. Um thermische Drifts auszugleichen, genügt es jedoch vollkommen, wenn die beim Bonden einer Anschlussfläche gewonnenen Informationen über den Offset der Kapillare 10 erst beim Bonden der nächsten oder übernächsten Anschlussfläche berücksichtigt werden.

Ein weiterer Vorteil der erfindungsgemässen Vorrichtungen besteht darin, dass unmittelbar nach dem Bonden eine Aufnahme der Bondverbindung gemacht werden kann, ohne dass der Bondkopf 7 wie bei den heutigen Systemen eine spezielle Bewegung durchführen muss, um die Optik über die Bondstelle zu bringen. Es ist dann zusätzlich möglich, die Lage der Bondverbindung zu analysieren und bei der Steuerung der Kapillare ebenfalls zu berücksichtigen. Die Schrägsicht eröffnet zudem neue Möglichkeiten zur Beurteilung der Qualität der hergestellten Drahtverbindungen, indem nun z.B. auch sichtbar wird, wenn ein Draht durchhängt.

## Patentansprüche

1. Vorrichtung zur Herstellung von Drahtverbindungen zwischen einer ersten Anschlussfläche (2) und einer zweiten Anschlussfläche (3), mit einer Kapillare (10), die sowohl zum Befestigen des Drahtes an den beiden Anschlussflächen (2, 3) als auch zur Drahtführung zwischen diesen dient, mit einem eine Optik (12) und eine Kamera (13) umfassenden Bilderkennungssystem zur Bestimmung der Lage mindestens der ersten Anschlussfläche (2), wobei die von der Kamera (13) aufgenommenen Bilder ein Koordinatensystem mit einer ersten und einer zweiten Bildachse aufspannen, **dadurch gekennzeichnet, dass** eine optische Achse (23) der Optik (12) auf der der Kapillare (10) zugewandten Seite der Optik (12; 14) mit der Vertikalen (21) einen von Null verschiedenen Winkel α₁ einschliesst, damit die Spitze (27) der Kapillare (10) unmittelbar vor dem Auftreffen auf der ersten Anschlussfläche (2) im Bild der Kamera (13) sichtbar wird.

2. Vorrichtung nach Anspruch 1, **dadurch gekennzeichnet, dass** das Bilderkennungssystem eine weitere Optik(14) umfasst, deren optische Achse (24) auf der der Kapillare (10) zugewandten Seite mit der Vertikalen (21) einen von Null verschiedenen Winkel α₂ einschliesst, dass das Bilderkennungssystem mittels mindestens eines unter dem Winkel α₁ aufgenommenen Bildes die Lage des Soll-Auftreffpunktes der Kapillare (10) auf der ersten Anschlussfläche (2) und die Lage der Spitze (27) der Kapillare (10) bezüglich der ersten Bildachse bestimmt, und dass das Bilderkennungssystem mittels mindestens eines unter dem Winkel α₂ aufgenommenen Bildes die Lage des Soll-Auftreffpunktes der Kapillare (10) auf der ersten Anschlussfläche (2) und die Lage der Spitze (27) der Kapillare (10) bezüglich der ersten Bildachse bestimmt.

3. Vorrichtung nach Anspruch 1 oder 2, **dadurch gekennzeichnet, dass** das Bilderkennungssystem die Lage des Soll-Auftreffpunktes der Kapillare (10) auf der ersten Anschlussfläche (2) bezüglich der ersten Bildachse und bezüglich der zweiten Bildachse bestimmt und dass das Bilderkennungssystem die Lage der Spitze (27) der Kapillare (10) bezüglich der zweiten Bildachse unter Berücksichtigung des Abbildes der Kapillare (10) als auch des Schattens der Kapillare (10) bestimmt.

4. Vorrichtung nach einem der Ansprüche 1 bis 3, **dadurch gekennzeichnet, dass** Beleuchtungsmittel (16) in der durch die optische Achse (23) der Optik (12) und die Vertikale (21) aufgespannten Ebene angeordnet sind, deren Licht unter einem Winkel δ zur Vertikalen (21) auf die erste Anschlussfläche (2) auftrifft, wobei der Winkel δ gleich gross wie der Winkel α₁ ist.

5. Vorrichtung nach einem der Ansprüche 1 bis 4, **dadurch gekennzeichnet, dass** aus einer allfälligen Abweichung der ermittelten Lage der Spitze (27) der Kapillare (10) von ihrem Soll-Auftreffpunkt auf der ersten Anschlussfläche (2) in dem durch die Bildachsen definierten Koordinatensystem ein Korrekturvektor für die Steuerung der Kapillare (10) bestimmt wird, und dass dieser Korrekturvektor beim Anfahren der ersten Anschlussfläche (2) oder beim Anfahren einer nachfolgenden ersten Anschlussfläche (2) für die Steuerung der Kapillare (10) berücksichtigt wird.

6. Vorrichtung nach einem der Ansprüche 1 bis 5, **dadurch gekennzeichnet, dass** das von den Beleuchtungsmitteln (16) abgestrahlte Licht im blauen Bereich des sichtbaren Spektrums liegt.
